# EUROPÄISCHE PATENTSCHRIFT

(11) **EP 1 169 898 B1**
(45) Veröffentlichungstag und Bekanntmachung des Hinweises auf die Patenterteilung: **21.08.2002**
(21) Anmeldenummer: 00925067.1
(22) Anmeldetag: 07.04.2000
(51) Int. Cl.: H05K 9/00, H05K 7/20

(54) **ANORDNUNG ZUM KÜHLEN EINER ELEKTRISCHEN BAUGRUPPE UND TECHNISCHES GERÄT**
DEVICE FOR COOLING AN ELECTRIC MODULE AND A TECHNICAL APPLIANCE
ENSEMBLE POUR REFROIDIR UN GROUPE ELECTRIQUE, ET APPAREIL TECHNIQUE

(30) Priorität: 13.04.1999 DE 19916594
(43) Veröffentlichungstag der Anmeldung: 09.01.2002
(73) Patentinhaber: SIEMENS AKTIENGESELLSCHAFT, 80333 München (DE)
(72) Erfinder: REECK, Guido, D-85521 Ottobrunn (DE); HOEFER, Bruno, D-82140 Olching (DE)
(86) Internationale Anmeldenummer: DE0001077
(87) Internationale Veröffentlichungsnummer: WO00062591

(56) Entgegenhaltungen:
- DE-A- 19 755 944
- US-A- 5 431 974

## Beschreibung

Die Erfindung betrifft eine Anordnung zum Kühlen einer in einem Gehäuse angeordneten elektrischen Baugruppe und ein technisches Gerät, insbesondere eine Basisstationen eines Mobilfunksystems oder drahtlosen Teilnehmeranschlußsystems.

In einem elektrisch betriebenen technischen Gerät führt die Verlustleistung stromdurchflossener Bauelemente und Baugruppen zu einer Erwärmung des Gerätes. Da elektrische Standardbauelemente für technische Geräte nur einen begrenzten zulässigen Betriebstemperaturbereich von beispielsweise bis zu 70°C aufweisen, werden diese durch Kühleinrichtungen gekühlt. Diese Kühleinrichtungen sind beispielsweise Ventilatoren, die in dem Gehäuse eine die elektrischen Bauelemente und Baugruppen um- bzw. durchströmende Luftströmung aufbauen und somit ein Abführen der erzeugten Wärmeleistung bewirken.

Bei einem Betrieb der technischen Geräte außerhalb geschlossener Räume oder in wiedrigen Verhältnissen innerhalb geschlossener Räume ist neben einer Wärmeabfuhr zusätzlich ein ausreichender Schutz vor Umwelteinflüssen wie beispielsweise Schmutzpartikeln und Flüssigkeiten vorzusehen. Hierbei müssen Schutzbestimmungen nach den spezifizierten IP-Klassen eingehalten werden, um eine dauerhafte Funktion der technischen Geräte sicherzustellen.

Aus der DE 19755944 ist bekannt, in einem Lufteinlaß eines Gehäuses einen Membranfilter für eine Oberflächenfilterung von Schmutzpartikeln aus einströmender Kühlluft und für ein Abscheiden von Flüssigkeiten vorzusehen. Im Vergleich zu einem beispielsweise aus der DE 19626778 bekannten Gehäuse mit einem Luft/Luft-Wärmetauscher, der eine vollständige Trennung eines inneren Kühlkreislaufes von einem äußeren Kühlkreislauf sicherstellt, kann durch den Einsatz des Membranfilters in einfacher Weise ein ausreichender Schutz der elektrischen Baugruppen für die oben genannten Einsatzgebiete des technischen Gerätes mit den entsprechenden Schutzbestimmungen erreicht werden. Gleichzeitig wird eine für die Kühlung benötigte Temperaturdifferenz zwischen der Temperatur der Umgebungsatmosphäre und der Temperatur im Inneren des Gehäuses verringert.

Ein derartiger Membranfilter basiert beispielsweise auf einem unter der Bezeichnung Goretex, Sympatex etc. für die Anwendung in Bekleidungsgegenständen bekannten Membranfilter. Die Membrane des Filters besteht aus einem feinen Geflecht oder Gewirk von Fasern, das eine sehr kleine Porengröße ermöglicht. Als Material wird hierfür beispielsweise PTFE (Polytetrafluorethylen), auch unter dem Namen Teflon bekannt, verwendet. Die Membrane wird in der Regel auf einem Trägermaterial wie beispielsweise Polyamid verwirklicht, um eine bestimmte Stabilität und Resistenz des Membranfilters zu erreichen.

Zusätzlich zu den Kriterien hinsichtlich von Schutzbestimmungen müssen weiterhin EMV-Richtlinien (EMV - Elektromagnetische Verträglichkeit) erfüllt werden, die einerseits einen Schutz der in dem Gehäuse des technischen Gerätes angeordneten elektrischen Baugruppen gegenüber elektromagnetischer Beeinflussung aus der Umgebung des-Gerätes und andererseits einen Schutz der Umgebung vor einer von den elektrischen Baugruppen ausgehenden elektromagnetischen Strahlung gewährleisten.

Aufgrund des verwendeten Kunststoffmaterials ist der Membranfilter für elektromagnetische Strahlung durchlässig und bewirkt somit keine hinreichende Abschirmung. Eine zusätzliche Abschirmung beispielsweise durch ein vor dem Membranfilter angeordneten Drahtgeflecht ist daher zur Erfüllung der EMV-Richtlinien notwendig. Dieses zusätzliche Drahtgeflecht ist jedoch nachteilig als ein weiteres Element des Gehäuses des technischen Gerätes vorzusehen und erhöht beispielsweise die Ausmaße des Gehäuses. Weiterhin erschwert es eine Wartung und Reinigung des Membranfilters.

Aus der US 5,431,974 ist eine Filteranordnung zur elektromagnetischen Abschirmung bekannt. Die Filteranordnung besteht dabei aus einem elektrisch leitfähigen Rahmen mit zumindest einer Öffnung, einer Scheibe aus porösem elektrisch leitfähigen Material, einer Schicht elektrisch leitfähigen Klebers sowie einem elektrisch leitfähigen Dichtungsmaterial. Als poröse Scheibe wird vorzugsweise aus synthetischen Polymeren gewählt, die an der Oberfläche durch elektrochemische Prozesse elektrisch leitfähig gemacht wurde.

Der Erfindung liegt die Aufgabe zugrunde, eine Anordnung zum Kühlen und ein technisches Gerät anzugeben, die bei einer bekannten Verwendung eines Membranfilters eine ausreichende elektromagnetische Abschirmung ohne die angegebenen Nachteile des Standes der Technik ermöglichen. Diese Aufgabe wird durch die Anordnung zum Kühlen nach den Patentansprüchen 1 und 2 sowie das technische Gerät nach Patentanspruch 11 gelöst. Vorteilhafte Weiterbildungen der Erfindung sind den abhängigen Patentansprüchen zu entnehmen.

Die erfindungsgemäße Anordnung zum Kühlen einer in einem Gehäuse angeordneten elektrischen Baugruppe weist zumindest einen in jeweils einem Lufteinlaß des Gehäuses angeordneten Membranfilter für eine Oberflächenfilterung von zumindest Schmutzpartikeln aus einströmender Kühlluft zum Kühlen der elektrischen Baugruppe sowie zumindest eine Kühleinrichtung zum Aufbauen einer Luftströmung in dem Gehäuse und zum Herausführen der gefilterten, aufgrund eines Durch- und/oder Umströmens der Baugruppe erwärmten Kühlluft aus zumindest einen Luftauslaß aus dem Gehäuse auf. Kennzeichnend weist der Membranfilter ein Geflecht aus einem elektrisch leitfähigen Material für eine elektromagnetische Abschirmung der elektrischen Baugruppe auf.

Die Ausgestaltung der erfindungsgemäßen Anordnung besitzt den Vorteil, daß durch eine Integration des elektrisch leitfähigen Geflechtes eine elektromagnetische Abschirmung erreicht wird, ohne daß eine zusätzliche Anordnung zur Abschirmung vorgesehen werden muß. Weiterhin werden die vorteilhaften Eigenschaften des Membranfilters nicht eingeschränkt. So ist beispielsweise eine einfache Reinigung des Filters ohne vorherige Demontage eines Abschirmgitters möglich. Das Gehäuse des technischen Gerätes kann hierdurch sehr kompakt verwirklicht werden.

Die erfindungsgemäße Anordnung kann in technischen Geräten mit zumindest einer elektrischen Baugruppe wie beispielsweise Basisstationen eines Mobilfunksystems oder drahtlosen Teilnehmeranschlußsystems (Access-Network-Systems), Verkehrsleiteinrichtungen, Versorgungseinrichtungen oder Schaltschränken für eine Steuerung von industriellen Maschinen eingesetzt werden. In gleicher Weise kann die erfindungsgemäße Anordnung beispielsweise in kleineren elektrischen Geräten wie beispielsweise einem tragbaren bzw. stationären Heimcomputer oder in elektrischen Meßgeräten eingesetzt werden.

Gemäß einer ersten Ausgestaltung der Erfindung scheidet der Membranfilter zusätzlich Flüssigkeiten an der Oberfläche ab, wodurch ein Einsatz des technischen Gerätes auch außerhalb geschlossener Räume bzw. unter widrigen Umgebungsbedingungen möglich ist.

Gemäß einer zweiten Ausgestaltung ist der Membranfilter als eine auf einem Trägermaterial aufgebrachte feinporige Membrane verwirklicht. Diese Ausgestaltung des Membranfilters ermöglicht vorteilhaft eine individuelle Anpassungsfähigkeit des Trägermaterials und/oder der Membrane an spezielle Einsatzbedingungen des technischen Gerätes. So kann beispielsweise ein gegen chemische Substanzen wie beispielsweise Säuren resistenter Filter für in der Produktion eingesetzte technische Geräte verwendet werden.

Gemäß einer auf der zweiten Ausgestaltung basierenden dritten Weiterbildung ist das elektrisch leitfähige Geflecht in dem Trägermaterial des Membranfilters eingewoben. Hierdurch wird vorteilhaft eine feste Verbindung des Geflechts mit dem Trägermaterial erreicht, wobei unter anderem beispielsweise die Stabilität des Membranfilters erhöht wird.

Alternativ zu der dritten Ausgestaltung ist das elektrisch leitfähige Geflecht auf dem Trägermaterial aufgebracht. Diese Ausgestaltung ermöglicht vorteilhaft eine einfache Herstellung des Membranfilters, wobei das elektrisch leitfähige Geflecht beispielsweise in einem zusätzlichen Herstellungsschritt auf den Membranfilter aufgebracht wird. Eine Verbindung zwischen dem Geflecht und dem Trägermaterial kann beispielsweise durch Klebetechnik erreicht werden.

Gemäß einer weiteren alternativen Ausgestaltung ist das elektrisch leitfähige Geflecht als Trägermaterial für die Membrane verwirklicht. Durch diese Ausgestaltung wird vorteilhaft die elektromagnetische Abschirmung direkt in den Membranfilter integriert, wodurch keine weiteren Arbeitsschritte bei der Herstellung des Membranfilters anfallen.

Die Membrane kann gemäß weiteren alternativen Ausgestaltungen aus einem als Teflon bekannten PTFE-Material oder aus einem elektrisch leitfähigen Material verwirklicht sein. Das PTFE-Material wird bereits vielfältig beispielsweise für wasserundurchlässige Bekleidungsstücke eingesetzt und kann aufgrund der Eigenschaften flexibel verschiedensten Anforderungen hinsichtlich der Porengröße angepaßt werden. Wird die Membrane aus einem elektrisch leitfähigen Material hergestellt, daß beispielsweise gleiche oder vergleichbare Eigenschaften besitzt, so kann vorteilhaft auf das zusätzliche elektrisch leitfähige Geflecht verzichtet werden.

Das elektrisch leitfähige Material kann gemäß einer weiteren Ausgestaltung als ein Metall-, ein Kunststoff- oder ein Keramikwerkstoff verwirklicht sein. Insbesondere Kunststoff- und Keramikwerkstoffe besitzen dabei vorteilhafte Eigenschaften beispielsweise hinsichtlich der Resistenz gegenüber Umwelteinflüssen, der Festigkeit sowie der Verarbeitbarkeit gegenüber bekannten Metallwerkstoffen.

Gemäß einer weiteren Ausgestaltung der Erfindung ist das elektrisch leitfähige Geflecht elektrisch mit dem Gehäuse verbunden, wobei dieses ebenfalls zumindest teilweise aus einem elektrisch leitfähigen Material verwirklicht ist. Unter elektrisch leitfähigen Geflecht kann hierbei erfindungsgemäß ein zusätzliches Geflecht, ein als Trägermaterial verwendeten Geflecht oder eine Membrane aus elektrisch leitfähigem Material verstanden werden. Die Verbindung mit dem Gehäuse bewirkt eine Erdung des Membranfilters, die alternativ auch mittels einer gesonderten geerdeten elektrischen Verbindung erreicht werden kann.

Einer weiteren Ausgestaltung der Erfindung zufolge wird die wirksame Oberfläche des Membranfilters durch eine periodische Faltung vergrößert, wodurch vorteilhaft ein Zusetzen des Filters vermindert und die Wartungsintervalle erhöht werden.

Vorteilhaft ist weiterhin ein zusätzlich an dem Luftauslaß des Gehäuses angeordneter erfindungsgemäßer Membranfilter. Diese Ausgestaltung ermöglicht beispielsweise eine Umkehrung der Kühlluftströmung in dem Gehäuse, um den Membranfilter an dem Lufteinlaß von Schmutzpartikeln zu befreien, ohne daß dabei Schmutzpartikel oder Flüssigkeiten durch den Luftauslaß in das Gehäuse gelangen können.

Gemäß einer weiteren Ausgestaltung besteht die Kühleinrichtung aus einem durch einen Motor angetriebenen Lüfterrad. Hierbei kann beispielsweise die Motordrehzahl und somit der Durchsatz der Kühlluft in dem Gehäuse in Abhängigkeit von der Temperatur im Gehäuse und/oder von der Temperatur der Umgebungsatmosphäre geregelt werden, wodurch vorteilhaft eine konstante Arbeitstemperatur der elektrischen Baugruppe und eine konstante Temperatur im Inneren des Gehäuses sichergestellt und somit vorteilhaft die Lebensdauer der elektrischen Baugruppe verlängert wird. Weiterhin kann die Drehzahl der Kühleinrichtung beispielsweise derart geregelt werden, daß die zulässigen Grenztemperaturen der elektrischen Baugruppe gerade nicht überschritten werden und somit die Geräuschemission der Anordnung durch die möglichst niedrige Drehzahl der Kühleinrichtung minimiert wird.

Die erfindungsgemäße Anordnung eignet sich insbesondere für einen Einsatz in technischen Geräten wie beispielsweise Basisstationen oder ähnlichen Outdoor-Anlagen eines Mobilfunksystems oder drahtlosen Teilnehmeranschlußsystems, sowie in Verkehrsleiteinrichtungen, Richtfunkeinrichtungen etc..

Ausführungsbeispiele der Erfindung werden anhand der beiliegenden Zeichnungen näher erläutert.

Dabei zeigen
- FIG 1: eine Basisstation eines Mobilfunksystems mit der erfindungsgemäßen Anordnung zum Kühlen von elektrischen Baugruppen in einer Vorderansicht,
- FIG 2: die erfindungsgemäße Anordnung in einer Seitenansicht,
- FIG 3: zwei beispielhafte Realisierungen des erfindungsgemäßen Membranfilters, und
- FIG 4: eine detailierte Darstellung des erfindungsgemäßen Membranfilters.

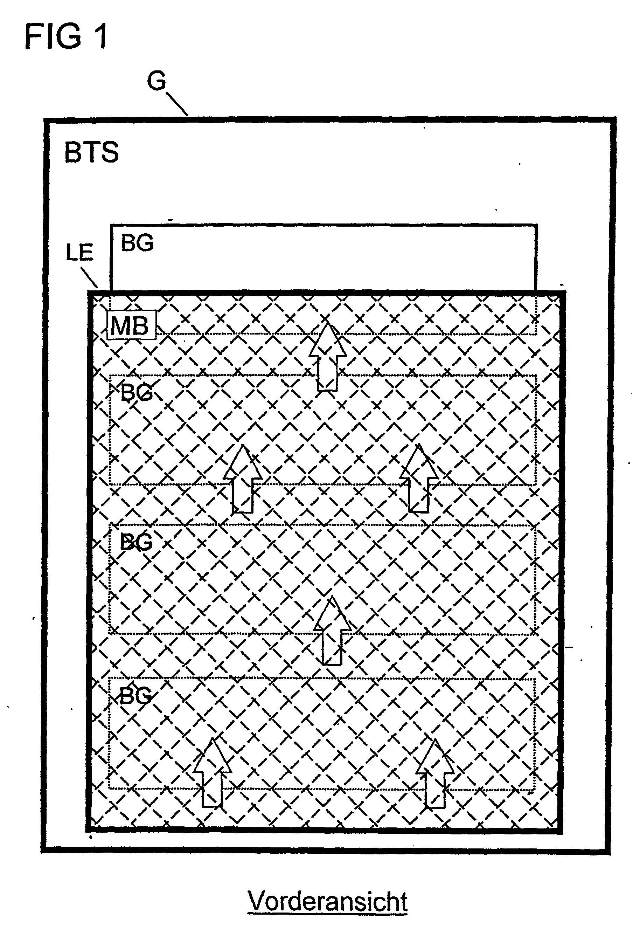

Ein technisches Gerät, wie beispielsweise eine Basisstation BTS eines Mobilfunksystems oder drahtlosen Teilnehmeranschlußsystems, nach dem Stand der Technik gemäß FIG 1 enthält mehrere elektrische Baugruppen BG. Während des Betriebes des elektrischen Gerätes führt die Verlustleistung der einzelnen elektrischen Baugruppen BG zu einer Erwärmung, wodurch die Notwendigkeit einer Kühlung entsteht, um eine zulässige Betriebstemperatur der Baugruppen nicht zu überschreiten.

Das in einer Vorderansicht dargestellte Gehäuse G des elektrischen Gerätes weist an der Stirnseite einen Lufteinlaß LE mit einem Membranfilter MB auf. Die Ausmaße des Lufteinlasses LE sind dabei beispielsweise derart dimensioniert, daß durch den Membranfilter MB einströmende Kühlluft aus der Umgebungsatmosphäre des technischen Gerätes die elektrischen Baugruppen BG jeweils von unten und gegebenenfalls von vorne durchströmen kann und somit ein Abkühlen der Baugruppen bewirkt. Die aktive Oberfläche des Membranfilters MB, welche beispielsweise durch eine Faltenbildung größer als der Lufteinlaß LE sein kann, ist so dimensioniert, daß der. Druckabfall der einströmenden Kühlluft durch eine Kühleinrichtung kompensiert werden kann bzw. trotz eines teilweisen Zusetzens des Membranfilters MB durch Schmutzpartikel oder Flüssigkeit noch eine ausreichende Menge Kühlluft einströmen kann.

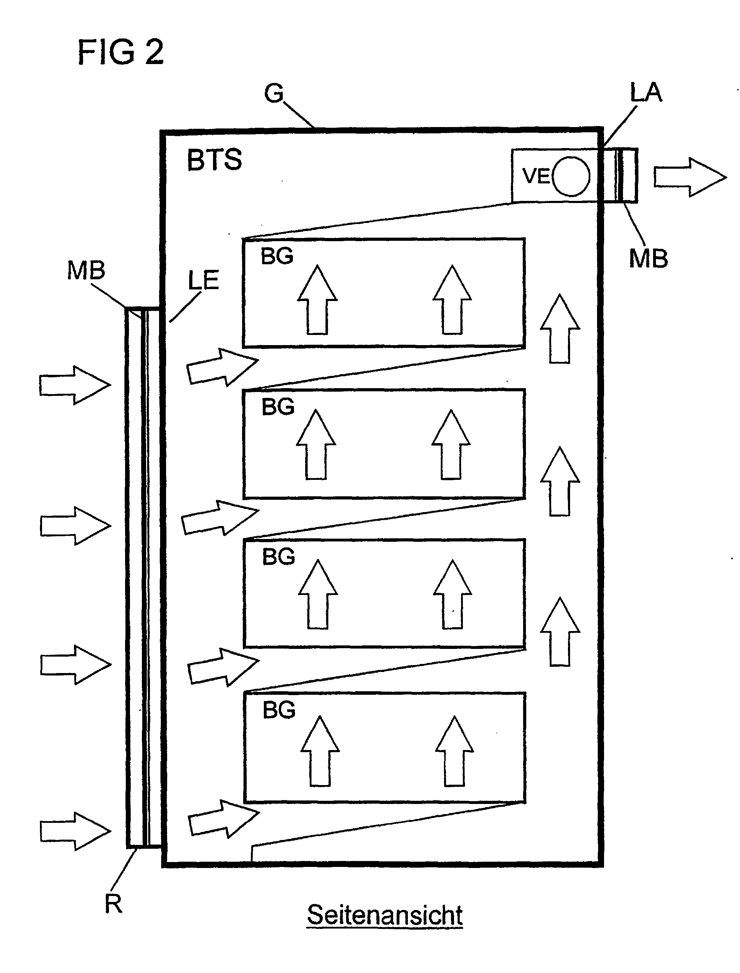

Die FIG 2 stellt das beschriebene technische Gerät in einer Seitenansicht dar, um den beispielhaften inneren Aufbau näher darzustellen. Auf der linken Seite des Gehäuses G ist vor dem Lufteinlaß LE ein Rahmen R mit dem Membranfilter MB angeordnet. Der zusätzliche Rahmen R ermöglicht eine schnelle Herausnahme des Membranfilters MB beispielsweise zu Wartungs- und Reinigungszwecken bzw. zum Austausch. Gleichzeitig ermöglicht der Rahmen R eine beschriebene Faltung des Membranfilters MB. Der Rahmen R kann zur Beschränkung der Ausmaße des technischen Gerätes auch in das Gehäuses G integriert werden.

Der Membranfilter MB ist als ein Oberflächenfilter ausgeführt, der die besonders vorteilhafte Eigenschaft besitzt, Schmutzpartikel und Flüssigkeiten der Umgebungsatmosphäre bereits an der Oberfläche der Membrane abzuscheiden, wodurch beispielsweise empfindliche elektronische Bausteine oder Schaltungen in den Baugruppen BG gegen derartige Umwelteinflüsse geschützt werden. Ein derartiger Membranfilter MB basiert beispielsweise auf einem unter der Bezeichnung Goretex, Sympatex etc. für die Anwendung in Bekleidungsgegenständen bekannten Membranfilter. Die Membrane des Filters besteht aus einem feinen Geflecht oder Gewirk von Fasern. Eine sehr kleine Porengröße verhindert ein Eindringen von Schmutzpartikeln in die Membrane und somit ein Zusetzen. Gleichwohl können sich an der Oberfläche der Membrane Schmutzpartikel ablagern, die jedoch in einfacher Weise entfernt werden können. In gleicher Weise können Flüssigkeiten bis zu einem speziellen Druck pro Flächeneinheit die Membrane nicht passieren.

Als Material wird für die Membrane beispielsweise PTFE, auch unter dem Namen Teflon bekannt, verwendet. Die Membrane wird in der Regel auf einem grob gewebten Trägermaterial wie beispielsweise Polyamid aufgetragen, um eine hohe Stabilität und Resistenz des Membranfilters MB zu erreichen.

Durch eine spezielle Auslegung des Membranfilters MB können Schutzbestimmungen nach den IP-Richtlinien bis beispielsweise IP55 erfüllt werden, wodurch ein Einsatz des technischen Gerätes außerhalb geschlossener Räume bzw. unter widrigen Umgebungsbedingungen, wie sie beispielsweise bei der industriellen Produktion auftreten, ermöglicht wird. Durch eine spezielle Auswahl des Membranfiltermaterials kann darüberhinaus eine individuelle Anpassung an die realen Umweltbedingungen, wie beispielsweise eine Resistenz gegen Säuren, erfolgen.

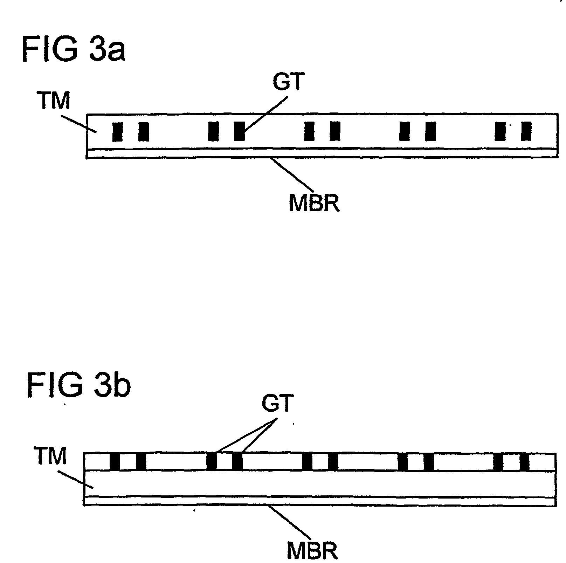

Bekannte, nach dem Stand der Technik hergestellte Membranfilter MBR bestehen aus oben beschriebenen Materialien, die für elektromagnetische Wellen durchlässig sind. Um EMV-Richtlinien (EMV - Elektromagnetische Verträglichkeit) zu erfüllen, muß das Gehäuse G des technischen Gerätes jedoch in dem Bereich des Lufteinlasses LE in gleicher Weise eine elektromagnetische Abschirmung aufweisen. Dieses wird im allgemeinen durch ein vor dem Lufteinlaß LE angebrachtes und elektrisch mit dem Gehäuse verbundenes Drahtgitter erreicht. Erfindungsgemäß wird dahingegen die elektromagnetische Abschirmung durch eine spezielle Ausgestaltung des Membranfilters MB erreicht, wodurch beispielsweise die Wartung und Reinigung des Membranfilters MB vereinfacht wird. Die möglichen Ausgestaltungen werden nachfolgend in den FIG 3a und 3b dargestellt.

Die Kühlung der elektrischen Baugruppen BG durch eine direkte Durchströmung des Gehäuses G mit Kühlluft besitzt den Vorteil einer gegen Null tendierenden notwendigen Temperaturdifferenz zwischen der Temperatur der Umgebungsatmosphäre bzw. der Temperatur der einströmenden Kühlluft und der Temperatur im Inneren des Gehäuses G, wodurch der Betrieb der elektrischen Baugruppen BG auch bei einer Temperatur der Umgebungsatmosphäre von beispielsweise +70°C, die der Grenztemperatur der Bauelemente entspricht, vermindert um den Grad der inneren Erwärmung, gesichert ist.

Eine Kühlanordnung VE, die beispielsweise in dem oberen Bereich der rückseitigen Gehäusewand angeordnet ist, saugt die bei der Durch- bzw. Umströmung der elektrischen Baugruppen BG erwärmte Luft an und führt sie durch einen Luftauslaß LA an die Umgebungsatmosphäre ab. Als Kühleinrichtungen VE werden beispielsweise ein oder mehrere Ventilatoren eingesetzt, die eine Luftströmung erzeugen. Eine Kühlung mittels einer natürlichen Konvektion ist für einen sicheren Betrieb der Baugruppen BG unterhalb der Grenztemperatur nicht ausreichend, wenn aufgrund einer hohen internen Verlustleistung eine starke Erwärmung der Baugruppen BG auftritt.

Zur Regelung der Temperatur im Inneren des Gehäuses G wird die Drehzahl des Ventilators geregelt. Zur Erfassung von Parametern für diese Regelung können beispielsweise in dem Bereich des Lufteinlasses LE und an verschiedenen Stellen innerhalb des Gehäuses G Temperaturfühler vorgesehen werden, die permanent die Temperaturen der einströmenden Kühlluft und der Atmosphäre im Inneren des Gehäuses G ermitteln. Bei dieser Regelung wird durch die Drehzahl des Ventilators der Kühleinrichtung VE der Durchsatz der Kühlluft in dem Gehäuse G verändert, um'beispielsweise eine konstante Temperatur im Inneren des Gehäuses G unabhängig von der Temperatur der Umgebungsatmosphäre zu erhalten. Eine konstante Betriebstemperatur der Baugruppen BG wirkt sich beispielsweise positiv auf die Betriebsdauer der elektronischen Bauteile und der Hochleistungsschaltkreise aus. Zusätzlich ermöglicht eine stets niedrig gehaltene Drehzahl der Kühleinrichtung VE, unter der Bedingung, daß die Grenztemperatur der Bauelemente nicht überschritten wird, eine Minimierung der Geräuschemission des technischen Gerätes. Weiterhin kann durch die Regelung bei einem Kaltstart des Gerätes anfangs von dem Betrieb der Kühleinrichtung VE abgesehen werden, um die Baugruppen BG schnell auf die gewünschte Betriebstemperatur zu erwärmen und erst nach Erreichen dieser Betriebstemperatur eine weitere Regelung der Kühleinrichtung VE zum Beibehalten der Betriebstemperatur durchzuführen.

Bei einer Wartung des technischen Gerätes kann beispielsweise durch eine Umkehrung der Drehrichtung oder eine Änderung der Fügelstellung des Lüfterrades der Kühleinrichtungen VE die Luftströmung in dem Gehäuse G umgekehrt werden, wodurch Kühlluft durch den Luftauslaß LA in das Gehäuse G einströmt und durch den Membranfilter MB herausgeführt wird. Dabei werden an der Oberfläche des Membranfilters MB abgesetzte Schmutzpartikel abgelöst und somit eine Reinigung des Membranfilters MB erreicht. Dieser Reinigungsvorgang kann beispielsweise auch durch eine permanente Messung des Luftdurchsatzes in Abhängigkeit von der Drehzahl der Kühlanordnung VE bei einem Unterschreiten eines fest vorgegebenen Wertes initiiert werden, wobei das gemessene Verhältnis den Grad der Verschmutzung des Membranfilters MB angibt. Vorteilhaft wird dabei in dem Luftauslaß LA ebenfalls ein Membranfilter MB angeordnet, so daß auch bei der Umkehrung der Luftströmung keine Schmutzpartikel oder Flüssigkeit in das Gehäuse G gelangen kann.

Durch eine zueinander beabstandete Anordnung der Baugruppen BG wird eine Durchströmung bzw. Umströmung der Baugruppen BG ermöglicht. Nach einer bekannten Bauart bestehen die Baugruppen BG beispielsweise aus einem Einschubgehäuse mit darin befindlichen elektronischen Bauelementen und Hochleistungsschaltkreisen. Die Einschubgehäuse sind mit Lüftungsschlitzen ausgestattet, durch die Kühlluft zu den Bauelementen und Schaltkreisen gelangen kann. Unter Baugruppen BG werden im Umfang der Erfindung weiterhin alle elektrischen Einrichtungen eines technischen Gerätes verstanden. So sind hierzu beispielsweise in einem Personal-Computer verwirklichte Leiterplatten sowie Peripherieeinheiten wie beispielsweise Festplatten zu zählen.

Die Anordnung der FIG 2 weist in den Räumen zwischen den einzelnen Baugruppen BG sowie unter der untersten und über der obersten Baugruppe BG Luftleiteinrichtungen auf, die die Aufgabe besitzen, durch den Membranfilter MB einströmende Kühlluft gleichmäßig über die Grundfläche der jeweiligen Baugruppe BG zu verteilen, so daß es zu einer homogenen Durchströmung der gesamten Baugruppe BG kommt. Weiterhin können die Luftleiteinrichtungen zur gegenseitigen elektromagnetischen Abschirmen der Baugruppen BG in Hinblick auf die Erfüllung der EMV-Bestimmungen verwendet werden.

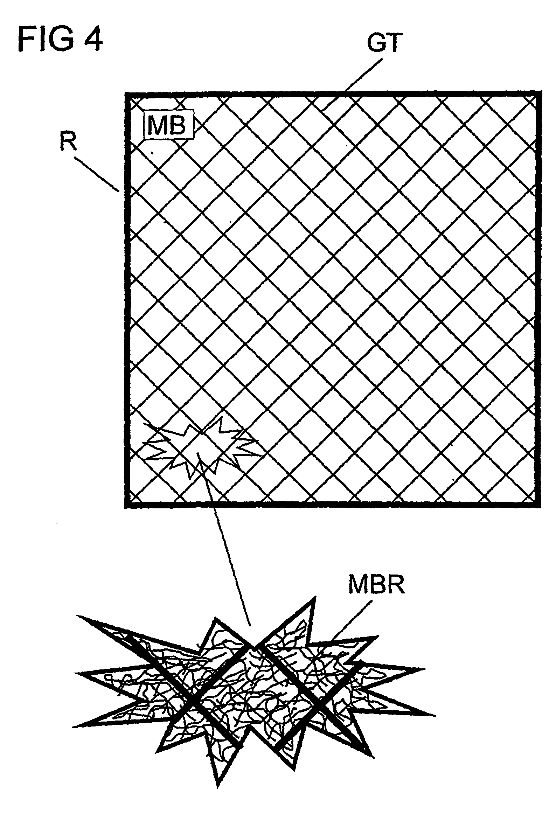

Die FIG 3a und FIG 3b zeigen jeweils einen erfindungsgemäßen Membranfilter MB in einer Schnittdarstellung. Ein Membranfilter MB nach dem Stand der Technik besteht aus einem grob gewebten und stabilen Trägermaterial TM mit einer darauf aufgebrachten Membrane MBR aus einem feinen Gewirk oder Filament. Erfindungsgemäß wird gemäß der FIG 3a in das Trägermaterial TM ein Geflecht GT aus einem elektrisch leitfähigen Material eingebracht. Dieses kann beispielsweise direkt bei der Herstellung des Trägermaterials TM eingewoben werden, und entsprechend der FIG 1 und FIG 4 beispielsweise eine Gitterförmige, als Ripstock bezeichnete Struktur ergeben. Der Vorteil des Einwebens ist darin zu sehen, daß durch die weiterhin sehr feinporige Oberfläche ein Festsetzen von Schmutzpartikeln an dem Geflecht und somit ein Zusetzen des Membranfilters MB verhindert wird. Als elektrisch leitfähiges Material wird ein Metall, ein Kunststoff oder eine Keramik eingesetzt, wobei weiterhin der Einsatz aller zukünftig die gewünschten Eigenschaften zeigenden Materialien in Erwägung gezogen werden kann. Das elektrisch leitfähige Geflecht GT wird mit Masse verbunden bzw. geerdet. Dieses kann durch eine Verbindung des Geflechts GT mit dem Gehäuse erfolgen, vorausgesetzt, dieses besteht ebenfalls zumindest teilweise aus einem elektrisch leitfähigen Material,

Gemäß der FIG 3b wird das elektrisch leitfähige Geflecht GT auf dem Trägermaterial TM aufgebracht und physikalisch mit diesem verbunden. Nicht figürlich dargestellt sind weitere erfindungsgemäße Varianten des Aufbaus des Membranfilters MB, wonach das Trägermaterial TM oder die Membrane MBR selbst aus einem elektrisch leitfähigen Material besteht. Bei diesen letzteren Ausgestaltungen kann auf ein zusätzliches elektrisch leitfähiges Geflecht verzichtet werden, wodurch der Aufbau und die Herstellung des Mebranfilters MB weiter vereinfacht wird.

In der FIG 4 ist der in einem Rahmen R angeordnete Membranfilter MB mit einem elektrisch leitfähigen Geflecht GT dargestellt. In einer unteren Ausschnittsvergrößerung ist die Struktur des Membranfilters MB in einer Draufsicht dargestellt. Deutlich wird die aus einem Gewirk einzelner dünner Fäden bestehende Membrane MBR, die eine sehr kleine Porengröße ermöglicht. Über der Membrane MBR ist das Geflecht GT aus elektrisch leitfähigen Material mit einem relativ großen Abstand zwischen den einzelnen Streben des Geflechts GT angeordnet. Die Dimensionierung des Geflechts erfolgt beispielsweise derart, daß einerseits eine möglichst geringe Oberfläche des Membranfilters MB durch das Geflecht GT versiegelt wird, andererseits eine ausreichende elektromagnetische Abschirmung und Stabilität des Membranfilters MB erreicht wird. Die in der FIG 1 und FIG 4 angegebene Struktur des elektrisch leitfähigen Geflechts GT ist beispielhaft und kann in dem Umfang der Erfindung in einer Vielzahl bekannter weiterer Strukturen verwirklicht werden.

## Patentansprüche

1. Anordnung zum Kühlen einer in einem Gehäuse (G) angeordneten elektrischen Baugruppe (BG), mit zumindest einem in jeweils einem Lufteinlaß (LE) des Gehäuses (G) angeordneten Membranfilter (MB) für eine Oberflächenfilterung von zumindest Schmutzpartikeln aus einströmender Luft zum Kühlen der elektrischen Baugruppe (BG), und zumindest einer Kühleinrichtung (VE) zum Aufbauen einer Luftströmung in dem Gehäuse (G) und zum Herausführen der gefilterten, aufgrund eines Durch- und/oder Umströmens der Baugruppe (BG) erwärmten Kühlluft aus zumindest einem Luftauslaß (LA) des Gehäuses (G),
**dadurch gekennzeichnet, daß**
der Membranfilter (MB) als eine auf einem Trägermaterial (TM) aufgebrachte feinporige Membrane (MBR) aus einem elektrisch leitfähigen Material für eine elektromagnetische Abschirmung der elektrischen Baugruppe (BG) verwirklicht ist.

2. Anordnung zum Kühlen einer in einem Gehäuse (G) angeordneten elektrischen Baugruppe (BG), mit zumindest einem in jeweils einem Lufteinlaß (LE) des Gehäuses (G) angeordneten Membranfilter (MB) für eine Oberflächenfilterung von zumindest Schmutzpartikeln aus einströmender Luft zum Kühlen der elektrischen Baugruppe (BG), und zumindest einer Kühleinrichtung (VE) zum Aufbauen einer Luftströmung in dem Gehäuse (G) und zum Herausführen der gefilterten, aufgrund eines Durch- und/oder Umströmens der Baugruppe (BG) erwärmten Kühlluft aus zumindest einem Luftauslaß (LA) des Gehäuses (G),
**dadurch gekennzeichnet, daß**
der Membranfilter (MB) als eine auf einem Trägermaterial (TM) aufgebrachte feinporige Membrane (MBR) verwirklicht ist, wobei ein Geflecht (GT) aus einem elektrisch leitfähigen Material in dem Trägermaterial (TM) des Membranfilters (MB) für eine elektromagnetische Abschirmung der elektrischen Baugruppe (BG) eingewoben ist.

3. Anordnung nach Anspruch 1 oder 2,
**dadurch gekennzeichnet, daß**
der Membranfilter (MB) zusätzlich Flüssigkeiten an der Oberfläche abscheidet.

4. Anordnung nach Anspruch 2,
**dadurch gekennzeichnet, daß**
das elektrisch leitfähige Geflecht (GT) als Trägermaterial (TM) für die Membrane (MBR) verwirklicht ist.

5. Anordnung nach einem der Ansprüche 2 bis 4,
**dadurch gekennzeichnet, daß**
die Membrane (MBR) aus einem PTFE-Material verwirklicht ist.

6. Anordnung nach einem vorhergehenden Anspruch,
**dadurch gekennzeichnet, daß**
als elektrisch leitfähiges Material ein Metall-, ein Kunststoff- oder ein Keramikwerkstoff verwendet wird.

7. Anordnung nach einem vorhergehenden Anspruch,
**dadurch gekennzeichnet, daß**
das elektrisch leitfähige Geflecht (GT) elektrisch mit dem Gehäuse (G) verbunden ist, wobei das Gehäuse ebenfalls zumindest teilweise aus einem elektrisch leitfähigen Material verwirklicht ist.

8. Anordnung nach einem vorhergehenden Anspruch,
**dadurch gekennzeichnet, daß**
die wirksame Oberfläche des Membranfilters (MB) durch eine periodische Faltung vergrößert ist.

9. Anordnung nach einem vorhergehenden Anspruch,
**dadurch gekennzeichnet, daß**
zusätzlich an dem Luftauslaß (LA) ein Membranfilter (MB) mit einem elektrisch leitfähigen Geflecht (GT) angeordnet ist.

10. Anordnung nach einem vorhergehenden Anspruch,
**dadurch gekennzeichnet, daß**
die Kühleinrichtung (VE) als ein durch einen Motor angetriebenes Lüfterrad verwirklicht ist.

11. Technisches Gerät mit einer Anordnung nach einem vorhergehenden Anspruch.

12. Technisches Gerät nach dem vorherigen Anspruch,
das als eine Basisstation (BTS) eines Mobilfunksystems und/oder eines drahtlosen Teilnehmeranschlußsystems verwirklicht ist.

## Claims

1. Arrangement for cooling an electrical module (BG) arranged in a housing (G), with at least one membrane filter (MB), arranged in an air inlet (LE) of the housing (G) in each case, for a superficial filtering of at least dirt particles from inflowing air for cooling the electrical module (BG), and at least one cooling device (VE) for establishing an air flow in the housing (G) and for discharging the filtered cooling air, heated up on account of flowing through or around the module (BG), out of at least one air outlet (LA) of the housing (G), **characterized in that** the membrane filter (MB) is provided in the form of a fine-pored membrane (MBR) of an electrically conductive material for an electromagnetic shielding of the electrical module (BG), applied to a backing material (TM).

2. Arrangement for cooling an electrical module (BG) arranged in a housing (G), with at least one membrane filter (MB), arranged in an air inlet (LE) of the housing (G) in each case, for a superficial filtering of at least dirt particles from inflowing air for cooling the electrical module (BG), and at least one cooling device (VE) for establishing an air flow in the housing (G) and for discharging the filtered cooling air, heated up on account of flowing through and/or around the module (BG), out of at least one air outlet (LA) of the housing (G), **characterized in that** the membrane filter (MB) is provided in the form of a fine-pored membrane (MBR) applied to a backing material (TM), a netting (GT) of an electrically conductive material being woven into the backing material (TM) of the membrane filter (MB) for an electromagnetic shielding of the electrical module (BG).

3. Arrangement according to Claim 1 or 2, **characterized in that** the membrane filter (MB) additionally separates out liquids at the surface.

4. Arrangement according to Claim 2, **characterized in that**. the electrically conductive netting (GT) is provided in the form of a backing material (TM) for the membrane (MBR).

5. Arrangement according to one of Claims 2 to 4, **characterized in that** the membrane (MBR) is made from a PTFE material.

6. Arrangement according to a preceding claim, **characterized in that** a metal, plastic or ceramic material is used as the electrically conductive material.

7. Arrangement according to a preceding claim, **characterized in that** the electrically conductive netting (GT) is electrically connected to the housing (G), the housing likewise being made at least partially from an electrically conductive material.

8. Arrangement according to a preceding claim, **characterized in that** the effective surface area of the membrane filter (MB) is enlarged by a periodic folding.

9. Arrangement according to a preceding claim, **characterized in that** a membrane filter (MB) with an electrically conductive netting (GT) is additionally arranged at the air outlet (LA).

10. Arrangement according to the preceding claim, **characterized in that** the cooling device (VE) is provided in the form of a fan impeller driven by a motor.

11. Technical appliance with an arrangement according to a preceding claim.

12. Technical appliance according to the preceding claim, which is provided in the form of a base station (BTS) of a mobile radio system and/or a wireless subscriber line system.

## Revendications

1. Ensemble pour refroidir un groupe électrique (BG) placé dans un boîtier (G), comprenant au moins un filtre à membrane (MB) disposé dans respectivement une entrée d'air (LE) du boîtier (G) et destiné à une filtration en surface du moins de particules polluantes provenant de l'air entrant pour refroidir ledit groupe électrique (BG), et au moins un dispositif de refroidissement (VE) destiné à produire un écoulement d'air dans le boîtier (G) et à évacuer l'air de refroidissement filtré et réchauffé en raison d'une circulation au travers et/ou autour du groupe électrique (BG) par au moins une sortie d'air (LA) du boîtier (G), **caractérisé en ce que** le filtre à membrane (MB) est réalisé comme membrane microporeuse (MBR) en matériau électroconducteur appliquée sur un matériau support (TM) pour assurer un blindage électromagnétique du groupe électrique (BG).

2. Ensemble pour refroidir un groupe électrique (BG) placé dans un boîtier (G), comprenant au moins un filtre à membrane (MB) disposé dans respectivement une entrée d'air (LE) du boîtier (G) et destiné à une filtration en surface du moins de particules polluantes provenant de l'air entrant pour refroidir ledit groupe électrique (BG), et au moins un dispositif de refroidissement (VE) destiné à produire un écoulement d'air dans le boîtier (G) et à évacuer l'air de refroidissement filtré et réchauffé en raison d'une circulation au travers et/ou autour du groupe électrique (BG) par au moins une sortie d'air (LA) du boîtier (G), **caractérisé en ce que** le filtre à membrane (MB) est réalisé comme membrane microporeuse (MBR) appliquée sur un matériau support (TM), un treillis (GT) en matériau électroconducteur étant incorporé dans le matériau support (TM) du filtre à membrane (MB) pour assurer un blindage électromagnétique du groupe électrique (BG).

3. Ensemble selon la revendication 1 ou 2, **caractérisé en ce que** le filtre à membrane (MB) sépare en outre des liquides à la surface.

4. Ensemble selon la revendication 2, **caractérisé en ce que** le treillis électroconducteur (GT) est réalisé comme matériau support (TM) pour la membrane (MBR).

5. Ensemble selon l'une quelconque des revendications 2 à 4, **caractérisé en ce que** la membrane (MBR) est réalisée en matériau PTFE.

6. Ensemble selon l'une quelconque des revendications précédentes, **caractérisé en ce qu'**un matériau métallique, plastique ou céramique est utilisé comme matériau électroconducteur.

7. Ensemble selon l'une quelconque des revendications précédentes, **caractérisé en ce que** le treillis électroconducteur (GT) est relié électriquement au boîtier (G), ledit boîtier étant réalisé également, au moins en partie, en matériau électroconducteur.

8. Ensemble selon l'une quelconque des revendications précédentes, **caractérisé en ce que** la surface active du filtre à membrane (MB) est augmentée par un pliage périodique.

9. Ensemble selon l'une quelconque des revendications précédentes, **caractérisé en ce qu'**un filtre à membrane (MB) pourvu d'un treillis électroconducteur (GT) est prévu en outre au niveau de la sortie d'air (LA).

10. Ensemble selon l'une quelconque des revendications précédentes, **caractérisé en ce que** le dispositif de refroidissement (VE) est réalisé comme roue de ventilateur entraînée par un moteur.

11. Appareil technique doté d'un ensemble selon l'une quelconque des revendications précédentes.

12. Appareil technique selon la revendication précédente, réalisé comme station de base (BTS) d'un système de radiocommunications mobiles et/ou d'un système de lignes d'abonné sans fil.
